# EUROPÄISCHE PATENTSCHRIFT

(11) **EP 2 561 734 B1**
(45) Veröffentlichungstag und Bekanntmachung des Hinweises auf die Patenterteilung: **14.05.2014**
(21) Anmeldenummer: 11728813.4
(22) Anmeldetag: 22.06.2011
(51) Int. Cl.: E05D 7/04, H05K 5/02

(54) **ANORDNUNG ZUM SCHWENKBAREN VERBINDEN EINES ERSTEN GEHÄUSETEILS MIT EINEM ZWEITEN GEHÄUSETEIL EINES VERTEILERSCHRANKS UND VERTEILERSCHRANK**
ARRANGEMENT FOR PIVOTABLY CONNECTING A FIRST HOUSING PART TO A SECOND HOUSING PART OF A DISTRIBUTION CABINET AND DISTRIBUTION CABINET
DISPOSITIF PERMETTANT DE RELIER DE MANIÈRE PIVOTANTE UNE PREMIÈRE PARTIE DE BOÎTIER À UNE SECONDE PARTIE DE BOÎTIER D'UNE ARMOIRE DE DISTRIBUTION, ET ARMOIRE DE DISTRIBUTION

(30) Priorität: 09.07.2010 DE 102010026679
(43) Veröffentlichungstag der Anmeldung: 27.02.2013
(73) Patentinhaber: Siemens Aktiengesellschaft, 80333 München (DE)
(72) Erfinder: MÜLLER, Gerhard, 93492 Treffelstein (DE); ZEMPELIN, Jens, 93161 Sinzing (DE)
(86) Internationale Anmeldenummer: PCT/EP2011/060486
(87) Internationale Veröffentlichungsnummer: WO 2012/004130

(56) Entgegenhaltungen:
- EP-A1- 1 288 415
- DE-A1-102005 022 537
- US-A- 5 379 487
- US-B1- 7 603 746

## Beschreibung

Die Erfindung betrifft eine Anordnung zum schwenkbaren Verbinden eines ersten Gehäuseteils mit einem zweiten Gehäuseteil eines Verteilerschranks. Weiterhin betrifft die Erfindung einen Verteilerschrank, welcher ein erstes Gehäuseteil, ein relativ dazu schwenkbares zweites Gehäuseteil, sowie eine Anordnung zum schwenkbaren Verbinden des ersten Gehäuseteils mit dem zweiten Gehäuseteil aufweist.

Verteilerschränke, welche auch als Elektroinstallationsverteiler, als Verteilerkasten oder schlicht als Verteiler bezeichnet werden, werden in der Elektroinstallationstechnik eingesetzt. Dabei handelt es sich um einen verschließbaren Kasten zur Verteilung des elektrischen Stromes, in dem elektrische und/oder elektronische Komponenten einer Anlage - beispielsweise einer einzelnen Maschine, einer Fertigungsanlage oder eines Gebäudes - untergebracht und vor Umgebungseinflüssen geschützt werden können. Weiterhin werden durch den Elektroinstallationsverteiler auch umstehende Personen vor elektrischem Schlag geschützt. Derartige Elektroinstallationsverteiler können als Wand- oder Standverteiler ausgebildet sein und - je nach Anwendung - aus Kunststoff, aus lackiertem Stahlblech oder aus Aluminiumblech in verschiedenen Bauformen und Baugrößen gefertigt sein.

In einem Elektroinstallationsverteiler können verschiedene elektrische Bauelemente bzw. Elektroinstallationsgeräte, beispielsweise Sicherungen, Leitungsschutzschalter, Relais, Schütze oder Fehlerstromschutzschalter angeordnet werden, so dass sie durch den Verteiler vor äußeren Einflüssen wie beispielsweise Staub oder Feuchtigkeit sowie vor äußerer mechanischer Krafteinwirkung oder unbefugtem Zugriff geschützt sind. Im Inneren des Elektroinstallationsverteilers sind zumeist Halterungen zur Strukturierung des Innenaufbaus des Verteilers sowie Stromführungssysteme zum Anschluss der elektrischen und/oder elektronischen Komponenten vorgesehen. Derartige Elektroinstallationsverteiler sind allgemein aus der Druckschrift DE 10 2005 022 537 B4 oder auch aus der Druckschrift DE 10 2006 054 429 A1 bekannt.

Um die Schutzfunktion des Verteilers bei gleichzeitig guter Zugänglichkeit zu realisieren weisen Verteilerschränke verschließbare Öffnungen auf, welche zumeist frontseitig angeordnet sind und mit Hilfe einer oder mehrerer Türen verschließbar sind. Heutzutage werden zur Kopplung der Türen mit dem Verteilerschrank zumeist Kunststoffscharniere verwendet, welche zumeist aus drei Kunststoffteilen bestehen. Bei einer großen und entsprechend schweren Türe kann es vorkommen, dass die Kunststoffteile der Scharniere unter dem Gewicht der Türe nachgeben. Dies führt dazu, dass die ursprüngliche Einstellung der Türe nicht mehr gewährleistet ist, was beispielsweise zu hängenden Türen führen kann, welche sich nur noch schlecht öffnen oder schließen lassen.

Es ist deshalb die Aufgabe der vorliegenden Erfindung, eine Anordnung zum schwenkbaren Verbinden eines ersten Gehäuseteils mit einem zweiten Gehäuseteils eines Verteilerschranks sowie einen Verteilerschrank mit einer derartigen Anordnung bereitzustellen, welche die oben genannten Nachteile überwinden.

Diese Aufgabe wird durch die erfindungsgemäße Anordnung zum schwenkbaren Verbinden zweier Gehäuseteile eines Verteilerschranks sowie durch den erfindungsgemäßen Verteilerschrank gemäß den unabhängigen Ansprüchen gelöst. Vorteilhafte Ausgestaltungen sind Gegenstand der abhängigen Ansprüche.

Die erfindungsgemäße Anordnung zum schwenkbaren Verbinden eines ersten Gehäuseteils mit einem zweiten Gehäuseteil eines Verteilerschranks umfasst ein erstes Scharnierelement, welches mittels einer Positionierschraube an einer Seitenwand des ersten Gehäuseteils befestigbar ist und ein Achsglied aufweist, welches zur Realisierung einer Drehbewegung des zweiten Gehäuseteils um eine Drehachse vorgesehen ist. Weiterhin umfasst die Anordnung ein zweites Scharnierelement, welches fest mit dem zweiten Gehäuseteil koppelbar ist und eine Aufnahme für das Achsglied aufweist, um das erste Gehäuseteil mit dem zweiten Gehäuseteil schwenkbar zu verbinden. Dabei weist das erste Scharnierelement einen Gewindebolzen auf, der in eine Gewindebohrung des ersten Scharnierelements eingeschraubt ist, so dass die Position des Achsgliedes relativ zum ersten Schrankteil in einer y-Richtung, welche quer zur Drehachse und im Wesentlichen senkrecht zur Seitenwand des ersten Gehäuseteils orientiert ist, einstellbar ist. Dabei weist das erste Scharnierelement eine Konterschraube auf, welche derart mit dem Gewindebolzen zusammenwirkt, dass bei Anziehen der Konterschraube die Position des ersten Scharnierelements in y-Richtung fixiert wird.

Hieraus ergibt sich der Vorteil, dass die relative Lage des ersten Gehäuseteils zum zweiten Gehäuseteil auch im bereits montierten Zustand durch Lösen der Konterschraube und Nachstellen des Gewindebolzens auf einfache Art und Weise nachjustiert werden kann. Weiterhin ist es möglich, die Verbindung des ersten Gehäuseteils mit dem zweiten Gehäuseteil durch Lösen der Positionierschraube schnell und einfach zu lösen, beispielsweise um eine bessere Zugänglichkeit zum Inneren des Verteilerkastens zu erhalten.

In einer vorteilhaften Weiterbindung der Anordnung ist die Konterschraube in einer Bohrung des Gewindebolzens drehbar gelagert und weist ein Innengewinde auf, mittels dessen die Konterschraube gegen die Positionierschraube verschraubbar ist, um den Gewindebolzen in y-Richtung zu fixieren. Diese konstruktive Anordnung der Konterschraube ermöglicht eine kompakte Gestaltung der Scharnier-Anordnung.

In einer weiteren vorteilhaften Weiterbindung der Anordnung weisen die einzelnen Elemente des ersten Scharnierelements sowie des zweiten Scharnierelements metallischen Werkstoff auf, um eine Erdungsverbindung zwischen dem ersten Gehäuseteil und dem zweiten Gehäuseteil zu ermöglichen. Dabei können die einzelnen Elemente entweder vollständig aus einem elektrisch leitenden Werkstoff gefertigt sein, oder auch nur anteilig einen derartigen Werkstoff aufweisen, wobei eine Erdungskontaktierung zwischen dem ersten Gehäuseteil und dem zweiten Gehäuseteil zu gewährleisten ist. Ein zusätzliches Erdungskabel, wie es beispielsweise bei Verteilern der Schutzklasse 1 mit Kunststoffscharnieren engesetzt wird, ist damit nicht mehr erforderlich.

In einer weiteren vorteilhaften Weiterbindung der Anordnung weisen auch das erste und das zweite Gehäuseteil metallischen Werkstoff auf, so dass die Erdungsverbindung über am ersten und am zweiten Scharnierelement ausgebildete Kratznasen realisierbar ist. Mit Hilfe der Kratznasen kann eine eventuell vorhandene Lackierung auf den Blechen des ersten und/oder des zweiten Gehäuseteils aufgekratzt werden, so dass eine Erdungskontaktierung mit dem darunter liegenden Metall gewährleistet ist.

In einer weiteren vorteilhaften Weiterbindung der Anordnung ist das erste Scharnierelement durch zumindest ein Teil des ersten Gehäuseteils formschlüssig gehaltert. Auf diese Weise wird ein Großteil des Gewichts des ersten Scharnierelements von der formschlüssigen Halterung aufgenommen. Die Biegebelastung der Positionierschraube wird dadurch deutlich reduziert. Die Positionierschraube dient somit vorwiegend der exakten Festlegung der Position des ersten Scharnierelements relativ zum ersten Gehäuseteil und weniger der Aufnahme von Haltekräften. Die Positionierschraube sowie das anordnungsseitig ausgebildete Gegengewinde können somit schlanker dimensioniert werden, wodurch eine kompaktere Bauweise des ersten Scharnierteils ermöglicht wird. Ferner wird durch die formschlüssige Halterung eine stabile Verbindung des ersten Scharnierelements mit dem ersten Gehäuseteil erreicht; eine Dejustierung der Scharnier-Anordnung durch eine Verformung aufgrund zu hoher Krafteinwirkung auf das erste Scharnierelement wird dadurch weitgehend vermieden.

In einer weiteren vorteilhaften Weiterbindung der Anordnung ist das zweite Scharnierelement durch zumindest ein Teil des zweiten Gehäuseteils formschlüssig gehaltert. Die formschlüssige Halterung des zweiten Scharnierelements stellt eine einfach zu realisierende Möglichkeit dar, dessen Position relativ zum zweiten Gehäuseteil festzulegen. Ferner wird durch die formschlüssige Halterung des zweiten Scharnierelements eine stabile Lagerung erreicht, so dass eine Verformung Scharnier-Anordnung aufgrund zu hoher Krafteinwirkung auf das zweite Scharnierelement erschwert wird.

In einer weiteren vorteilhaften Weiterbindung der Anordnung ist die Position des zweiten Gehäuseteils relativ zum ersten Gehäuseteil in einer z-Richtung, welche parallel zur Drehachse orientiert ist, mit Hilfe eines am zweiten Scharnierelement ausgebildeten Einstellmittels veränderbar. Hierdurch wird eine weitere Einstellmöglichkeit der Scharnier-Anordnung in der z-Richtung realisiert.

In einer weiteren vorteilhaften Weiterbindung der Anordnung ist das Einstellmittel als Exzenter ausgebildet, dessen erstes Ende im zweiten Scharnierelement um eine quer zur Drehachse orientierte Achse drehbar gelagert ist, und dessen zweites Ende sich gegen das zweite Gehäuseteil abstützt. Ein Exzenter stellt eine einfach zu realisierende Möglichkeit dar, um die Einstellbarkeit in der z-Richtung konstruktiv auszuführen. Dabei ist ein Nachjustieren der Einstellung durch Verstellen des Exzenters auch im bereits montierten Zustand möglich.

In einer weiteren vorteilhaften Weiterbindung der Anordnung sind das erste Scharnierelement und/oder das zweite Scharnierelement durch ein zusätzliches Verschlusselement formschlüssig gehaltert. Dabei kann es sich beispielsweise um einen Schnappverschluss handeln, welcher bewirkt, dass das erste bzw. zweite Scharnierelement nach der Montage am ersten bzw. zweiten Gehäuseteil sicher gehaltert wird. Die Sicherheit der Anordnung gegen unbeabsichtigtes Lösen des ersten bzw. des zweiten Scharnierelements vom ersten bzw. zweiten Gehäuseteil wird dadurch deutlich verbessert.

In einer weiteren vorteilhaften Weiterbindung der Anordnung sind das erste Gehäuseteil als Schrankkorpus und das zweite Gehäuseteil als Schranktüre ausgebildet. In einer weiteren vorteilhaften Weiterbindung der Anordnung sind das erste Gehäuseteil als Schranktüre und das zweite Gehäuseteil als Schrankkorpus ausgebildet. Die Befestigung des ersten Scharnierelements kann sowohl schrankseitig als auch türseitig erfolgen; entsprechend ist das zweite Scharnierelement türseitig bzw. schrankseitig angeordnet. Auf diese Weise kann die Scharnier-Anordnung hinsichtlich der Einstellmöglichkeiten an die jeweilige Einsatzsituation angepasst werden. Die Flexibilität der Anordnung wird dadurch deutlich erhöht.

Der erfindungsgemäße Verteilerschrank weist ein erstes Gehäuseteil, ein relativ dazu schwenkbares zweites Gehäuseteil sowie eine Anordnung zum schwenkbaren Verbinden des ersten Gehäuseteils mit dem zweiten Gehäuseteil nach einem der Ansprüche 1 bis 7 auf.

Hinsichtlich der Vorteile des erfindungsgemäßen Verteilerschranks wird auf die Ausführungen zu den Vorteilen der erfindungsgemäßen Anordnung zum schwenkbaren Verbinden des ersten Gehäuseteils mit dem zweiten Gehäuseteil verwiesen.

Im Folgenden werden Ausführungsbeispiele der Anordnung unter Bezug auf die beigefügten Figuren näher erläutert. In den Figuren sind:

### Figuren

- 1A und 1B: schematische Schnittdarstellungen des ersten Scharnierelements in zwei Montageschritten;
- Figur 2: eine Explosionszeichnung des ersten Scharnierelements in einer schematischen Darstellung;
- Figuren 3A und 3B: schematische Darstellungen der Scharnier-Anordnung in mehreren Montageschritten.

In den verschiedenen Figuren der Zeichnung sind gleiche Teile stets mit dem gleichen Bezugszeichen versehen. Die Beschreibung gilt für alle Zeichnungsfiguren, in denen das entsprechende Teil ebenfalls zu erkennen ist.

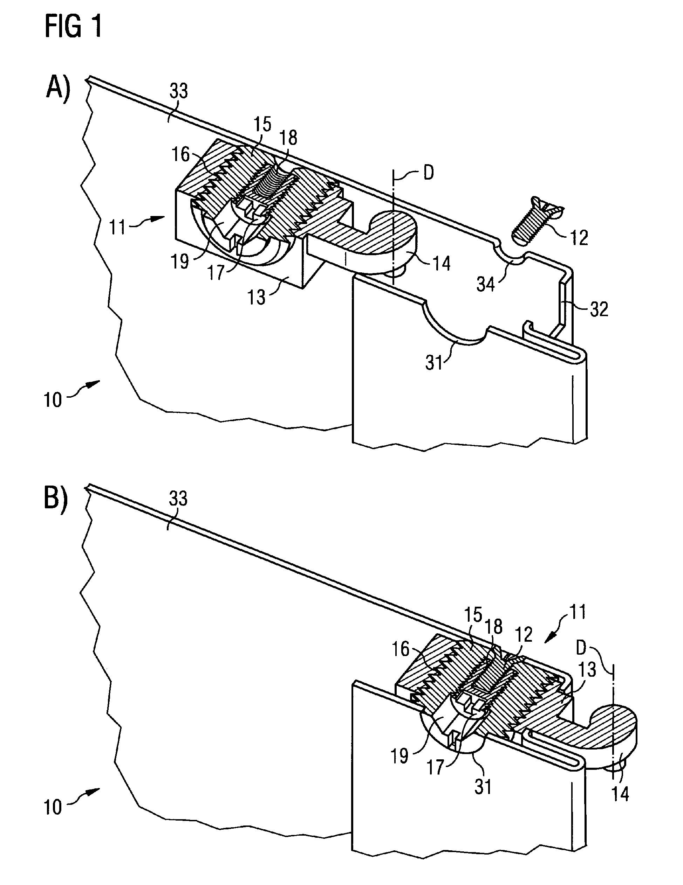

In den Figuren 1A und 1B ist das erste Scharnierelement 11 in zwei aufeinanderfolgenden Montageschritten schematisch dargestellt. Um die einzelnen Elemente des ersten Scharnierelements 11 sowie deren Zusammenwirken besser zu veranschaulichen, sind die Figuren 1A und 1B als Schnittdarstellungen ausgeführt. Figur 1A zeigt dabei das erste Scharnierelement 11 zu einem Zeitpunkt, bevor es an einem ersten Gehäuseteil 10 mit Hilfe einer Positionierschraube 12 befestigt wird. Das erste Gehäuseteil 10 weist dabei einen als Seitenwand 33 ausgebildeten Abschnitt auf. Diese weist in einer vordefinierten Position eine Durchgangsbohrung 34 zum Durchführen der Positionierschraube 12 auf, so dass das erste Scharnierelement 11 relativ zum ersten Gehäuseteil 10 mit Hilfe der Positionierschraube 12 in einer definierten Position befestigt werden kann.

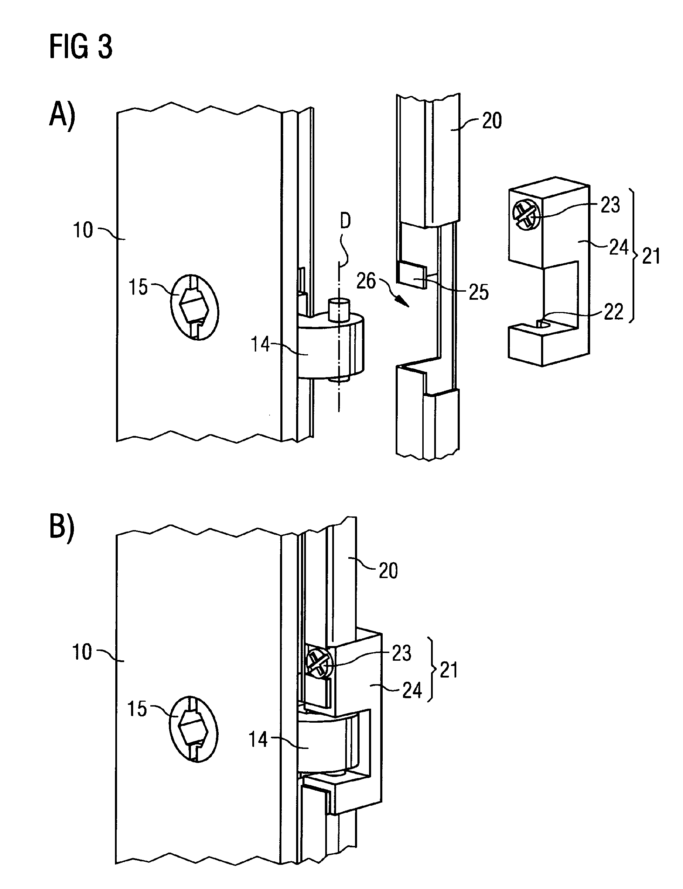

Figur 1B hingegen zeigt das erste Scharnierelement 11 in einem montierten Zustand an dem als Seitenwand 33 ausgebildeten Abschnitt des ersten Gehäuseteils 10. Das erste Scharnierelement 11 weist einen Grundkörper 13 auf, an den ein Achsglied 14 angeformt ist, welches zur Realisierung einer Drehbewegung eines zweiten Gehäuseteils 20 (siehe Figuren 3A bzw. 3B), um eine Drehachse D vorgesehen ist. Der Grundkörper 13 ist im vorliegenden Fall quaderförmig ausgebildet und weist eine Gewindebohrung 16 auf, in die ein Gewindebolzen 15 eingeschraubt ist. Zur Montage des ersten Scharnierelements 11 wird dieses in einem im ersten Gehäuseteil 10 ausgebildete, taschenartige Aufnahme eingeschoben und mithilfe der Positionierschraube 12 relativ zum ersten Gehäuseteil 10 fixiert. In diesem fixierten bzw. montierten Zustand des ersten Scharnierelements 11 ragt das Achsglied 14 durch eine im ersten Gehäuseteil 10 ausgebildete Öffnung 32 aus der Umfangskontur des ersten Gehäuseteils 10 heraus, so dass über das Achsglied 14 die Drehbewegung des zweiten Gehäuseteils 20 realisierbar ist.

Der Gewindebolzen 15 liegt im montierten Zustand mit seinem einen Ende an der Seitenwand 33 des ersten Gehäuseteils 10 an und ist mit seinem anderen Ende in einer in dem ersten Gehäuseteil 10 ausgebildeten Aufnahme 31 drehbar gelagert. Ferner wird das erste Scharnierelement 11 durch die Aufnahme 31 formschlüssig gehaltert, so dass ein Großteil der auf das erste Scharnierelement 31 wirkenden Belastung von der formschlüssigen Halterung aufgenommen wird. Hierdurch wird die Biegebelastung der Positionierschraube deutlich reduziert, wodurch eine kompaktere Bauweise des ersten Scharnierelements 31 realisierbar ist. Wird der Gewindebolzen 15 im montierten Zustand gedreht, beispielsweise mithilfe eines Schraubendrehers, so dreht sich der Grundkörper 13 nicht mit, da er sich gegen die im ersten Gehäuseteil 10 ausgebildete Öffnung 32 abstützt. Auf diese Weise kann der Abstand des Grundkörpers 13 zur Seitenwand des ersten Gehäuseteils 10 durch eine Drehung des Gewindebolzens 15 gegenüber der Gewindebohrung 16 eingestellt werden, ohne die Winkellage des ersten Scharnierelements 31 zu verändern. Der Grundkörper 13 und mit ihm die durch das Achsglied 14 definierte Drehachse D werden auf diese Weise senkrecht zur Seitenwand des ersten Gehäuseteils 10 bewegt.

Der Gewindebolzen 15 weist seinerseits eine Bohrung 19 auf, welche durchgängig ausgeführt und zur Aufnahme einer Konterschraube 17 vorgesehen ist. Die Konterschraube 17 weist ihrerseits ein Innengewinde 18 auf, welches in Richtung der Seitenwand 33 orientiert und zum Eindrehen der Positionierschraube 12 ausgebildet ist. Solange die Positionierschraube 12 nicht angezogen ist, d. h. nicht gegen die Konterschraube 17 verschraubt ist, kann der Gewindebolzen 15 verdreht werden, um den Abstand des Grundkörpers 13 zur Seitenwand des ersten Gehäuseteils 10 und damit der durch das Achsglied definierten Drehachse D relativ zur Seitenwand 33 des ersten Gehäuseteils 10 einzustellen. Wird jedoch die Positionierschraube 12 gegen die Konterschraube 17 fest angezogen, so wird damit auch der Gewindebolzen 15 gekontert, d. h. der Gewindebolzen 15 wird gegen die Seitenwand 33 gezogen und somit fixiert. Diese Position ist in Figur 1B dargestellt.

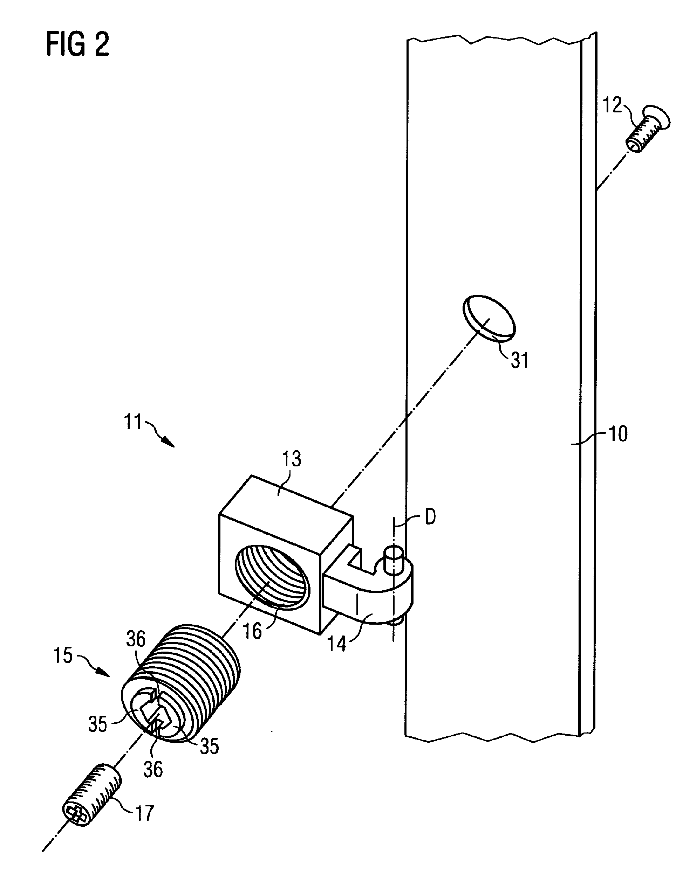

Figur 2 zeigt das erste Scharnierelement 11 mit all seinen Einzelteilen in einer Explosionsdarstellung. Dabei ist das im Grundkörper 13 ausgebildete Innengewinde 16, welches zur Aufnahme des Gewindebolzens 15 vorgesehen ist, gut zu erkennen. Der Gewindebolzen 15 weist eine konzentrisch zu seinem Außengewinde verlaufende Bohrung 19 auf, welche zur Aufnahme der Konterschraube 17 ausgebildet ist. Die Konterschraube 17 ist in der Bohrung 19 drehbar gelagert und weist ihrerseits ein Innengewinde (siehe Figur 1A) auf, über welches die Konterschraube 17 mit der Positionierschraube 12 verschraubt werden kann. An der der Seitenwand 33 abgewandten Seite weist der Gewindebolzen 15 einen ringartigen Vorsprung 35 auf, über dem der Gewindebolzen 15 in der Aufnahme 31 des ersten Gehäuseteils 10 drehbar gelagert und gehaltert ist. Der ringförmige Vorsprung 35 ist an zwei Stellen durch eine schlitzartige Einkerbung 36 unterbrochen, welche zur Aufnahme eines Schraubendrehers oder eines vergleichbaren Werkzeugs vorgesehen ist. Ferner ist der erste Abschnitt der Bohrung 19 als Innensechskant ausgebildet, so dass die Drehung des Gewindebolzens 15 auch mit Hilfe eines Sechskant- oder Inbusschlüssels erfolgen kann.

In den Figuren 3A und 3B ist die gesamte Scharnier-Anordnung, aufweisend das erste Scharnierelement 11 sowie ein zweites Scharnierelement 21, in zwei aufeinander folgenden Montageschritten schematisch dargestellt. Während in Figur 3B sowohl das erste Scharnierelement 11 als auch das zweite Scharnierelement 21 im montierten Zustand dargestellt sind, zeigt Figur 3A lediglich das erste Scharnierelement 11 im montierten Zustand am ersten Gehäuseteil 10, wohingegen das zweite Scharnierelement 21 im noch nicht montierten Zustand dargestellt ist. Das zweite Scharnierelement 21 weist einen Grundkörper 24 auf, in dem eine Aufnahme 22 für das Achsglied 14 des ersten Scharnierelements 11 vorgesehen ist. Weiterhin weist das zweite Scharnierelement 21 ein Einstellmittel 23 in Form einer Exzenterschraube auf, mit der die relative Lage des zweiten Scharnierelements 21 zum zweiten Gehäuseteil 20 in Richtung der Drehachse D variiert werden kann.

Zur Montage der Scharnieranordnung wird zunächst das Achsglied 15 in eine in einer Umkantung des zweiten Gehäuseteils 20 ausgebildete Aussparung 26 eingeführt. Anschließend wird das zweite Scharnierelement 21 in die Aussparung 26 eingeführt, derart, dass das Achsglied 14 des ersten Scharnierelements von der Aufnahme 22 des zweiten Scharnierelements 21 aufgenommen ist. Dabei wird das zweite Scharnierelement 21 in der Aussparung 26 quer zur Drehachse D formschlüssig gehaltert. Über einen am zweiten Gehäuseteil 20 im Bereich der Umkantung ausgebildeten Vorsprung 25 stützt sich der Schraubenkopf der Exzenterschraube 23 ab, so dass bei Drehung der Exzenterschraube die Lage des zweiten Scharnierelements 21 in Richtung der Drehachse D variierbar ist. Da hierdurch die relative Lage des zweiten Scharnierelements 21 zum Achsglied 14 in Richtung der Drehachse D nicht verändert wird, kann durch Drehen der Exzenterschraube 23 die Position des zweiten Gehäuseteils 20 relativ zum ersten Gehäuseteil 10 in Richtung der Drehachse D variiert werden.

Ferner können am zweiten Scharnierelement 21 Kratznasen (nicht dargestellt) ausgebildet sein, welche eine gegebenenfalls vorhandene Lackierung des zweiten Gehäuseteils 20 aufkratzen, um eine elektrisch leitende Verbindung zu dem darunter liegenden Blech herzustellen. Auf diese Weise ist eine Erdungskontaktierung des zweiten Scharnierelements 21 mit dem zweiten Gehäuseteil 20 realisierbar.

Mithilfe der erfindungsgemäßen Scharnieranordnung ist es folglich möglich, die Position des ersten Gehäuseteils relativ zum zweiten Gehäuseteil sowohl in einer y-Richtung, welche im Wesentlichen senkrecht zu einer Seitenwand des ersten Gehäuseteils orientiert ist, als auch in Richtung der Drehachse D, welche im Wesentlichen senkrecht zur y-Richtung orientiert ist, verstellt werden.

### Bezugszeichenliste

- 10: erstes Gehäuseteil
- 11: erstes Scharnierelement
- 12: Positionierschraube
- 13: Grundkörper
- 14: Achsglied
- 15: Gewindebolzen
- 16: Gewindebohrung
- 17: Konterschraube
- 18: Innengewinde
- 19: Bohrung

- 20: zweites Gehäuseteil
- 21: zweites Scharnierelement
- 22: Aufnahme
- 23: Einstellmittels / Exzenter
- 24: Grundkörper
- 25: Vorsprung
- 26: Aussparung

- 31: Aufnahme
- 32: Öffnung
- 33: Seitenwand
- 34: Durchgangsbohrung
- 35: ringförmiger Vorsprung
- 36: schlitzartige Einkerbung

- D: Drehachse

## Patentansprüche

1. Anordnung zum schwenkbaren Verbinden eines ersten Gehäuseteils (10) mit einem zweiten Gehäuseteil (20) eines Verteilerschranks, mit
- einem ersten Scharnierelement (11), welches mittels einer Positionierschraube (12) an einer Seitenwand des ersten Gehäuseteils (10) befestigbar ist und ein Achsglied (14) aufweist, welches zur Realisierung einer Drehbewegung des zweiten Gehäuseteils (20) um eine Drehachse (D) vorgesehen ist,
- einem zweiten Scharnierelement (21), welches fest mit dem zweiten Gehäuseteil (20) koppelbar ist und eine Aufnahme (22) für das Achsglied (14) aufweist, um das erste Gehäuseteil (10) mit dem zweiten Gehäuseteil (20) schwenkbar zu verbinden,
wobei das erste Scharnierelement (11) einen Gewindebolzen (15) aufweist, der in eine Gewindebohrung (16) des Scharnierelements (11) eingeschraubt ist, so dass die Position des Achsgliedes (14) relativ zum ersten Schrankteil (10) in einer y-Richtung, welche quer zur Drehachse und im Wesentlichen senkrecht zur Seitenwand des ersten Gehäuseteils (10) orientiert ist, einstellbar ist,
- wobei das erste Scharnierelement (11) eine Konterschraube (17) aufweist, welche derart mit dem Gewindebolzen (15) zusammenwirkt, dass bei Anziehen der Konterschraube (17) die Position des ersten Scharnierelements (11) in y-Richtung fixiert wird.

2. Anordnung nach Anspruch 1, wobei die Konterschraube (17) in einer Bohrung (19) des Gewindebolzens (15) drehbar gelagert ist und ein Innengewinde (18) aufweist, mittels dessen die Konterschraube (17) gegen die Positionierschraube (12) verschraubbar ist, um den Gewindebolzen (15) in y-Richtung zu fixieren.

3. Anordnung nach einem der vorangehenden Ansprüche, weisen die einzelnen Elemente des ersten Scharnierelements (11) sowie des zweiten Scharnierelements (21) einem metallischen Werkstoff auf, um eine Erdungsverbindung zwischen dem ersten Gehäuseteil (10) und dem zweiten Gehäuseteil (20) zu ermöglichen.

4. Anordnung nach Anspruch 3, wobei das erste und das zweite Gehäuseteil (10, 20) metallischem Werkstoff aufweisen und die Erdungsverbindung über am ersten und am zweiten Scharnierelement (11, 21) ausgebildete Kratznasen realisierbar ist.

5. Anordnung nach einem der vorangehenden Ansprüche, wobei die Position des zweiten Gehäuseteils (20) relativ zum ersten Gehäuseteil (10) in einer z-Richtung, welche parallel zur Drehachse (D) orientiert ist, mit Hilfe eines am zweiten Scharnierelement (21) ausgebildeten Einstellmittels (23) veränderbar ist.

6. Anordnung nach Anspruch 5, wobei das Einstellmittel als Exzenter (23) ausgebildet ist, dessen erstes Ende im zweiten Scharnierelement (21) um eine quer zur Drehachse (D) orientierte Achse drehbar gelagert ist, und dessen zweites Ende sich gegen das zweite Gehäuseteil (20) abstützt.

7. Anordnung nach einem der vorangehenden Ansprüche, wobei das erste Scharnierelement (11) und/oder das zweite Scharnierelement (21) durch ein zusätzliches Verschlusselement formschlüssig gehaltert sind.

8. Verteilerschrank mit einem ersten Gehäuseteil (10) und einen relativ dazu schwenkbaren zweiten Gehäuseteil (20) sowie mit einer Anordnung zum schwenkbaren Verbinden des ersten Gehäuseteils (10) mit dem zweiten Gehäuseteil (20) nach einem der Ansprüche 1 bis 7.

9. Verteilerschrank nach Anspruch 8, wobei das erste Scharnierelement (11) durch zumindest ein Teil des ersten Gehäuseteils (10) formschlüssig gehaltert ist.

10. Verteilerschrank nach einem der Ansprüche 8 oder 9, wobei das zweite Scharnierelement (21) durch zumindest ein Teil des zweiten Gehäuseteils (20) formschlüssig gehaltert ist.

11. Verteilerschrank nach einem der Ansprüche 8 bis 10, wobei das erste Gehäuseteil (10) als Schrankkorpus und das zweite Gehäuseteil (20) als Schranktüre ausgebildet sind.

12. Verteilerschrank nach einem der Ansprüche 8 bis 10, wobei das erste Gehäuseteil (10) als Schranktüre und das zweite Gehäuseteil (20) als Schrankkorpus ausgebildet sind.

## Claims

1. Arrangement for pivotably connecting a first housing part (10) to a second housing part (20) of a distribution cabinet, comprising
- a first hinge element (11) which can be attached to a side wall of the first housing part (10) by means of a positioning screw (12) and has an axis member (14) which is provided for implementing a rotary movement of the second housing part (20) about a rotational axis (D),
- a second hinge element (21) which can be rigidly coupled to the second housing part (20) and has a holder (22) for the axis member (14) in order to rotatably connect the first housing part (10) to the second housing part (20),
wherein the first hinge element (11) has a threaded stud (15) which is screwed into a threaded hole (16) of the hinge element (11) such that the position of the axis member (14) relative to the first cabinet part (10) can be adjusted in a y direction which is oriented transversely to the rotational axis and essentially perpendicularly to the side wall of the first housing part (10),
- wherein the first hinge element (11) has a lock screw (17) which interacts in such a manner with the threaded stud (15) that the position of the first hinge element (11) is fixed in the y direction when the lock screw (17) is tightened.

2. Arrangement according to claim 1, wherein the lock screw (17) is rotatably mounted in a hole (19) in the threaded stud (15) and has an internal thread (18) by means of which the lock screw (17) can be screwed against the positioning screw (12) in order to fix the threaded stud (15) in the y direction.

3. Arrangement according to one of the preceding claims,
wherein the individual elements of the first hinge element (11) and also of the second hinge element (21) consist of a metallic material in order to enable an earth connection between the first housing part (10) and the second housing part (20).

4. Arrangement according to claim 3, wherein the first and the second housing parts (10, 20) consist of a metallic material and the earth connection can be implemented by way of scratching projections formed on the first and the second hinge elements (11, 21).

5. Arrangement according to one of the preceding claims,
wherein the position of the second housing part (20) relative to the first housing part (10) can be changed in a z direction which is oriented parallel to the rotational axis (D) with the aid of an adjustment means (23) configured on the second hinge element (21).

6. Arrangement according to claim 5, wherein the adjustment means is designed as an eccentric (23), the first end of which is rotatably mounted around an axis oriented transversely with respect to the rotational axis (D) in the second hinge element (21), and the second end of which is supported against the second housing part (20).

7. Arrangement according to one of the preceding claims,
wherein the first hinge element (11) and/or the second hinge element (21) are/is supported in form-locked fashion by an additional fastener element.

8. Distribution cabinet having a first housing part (10) and a second housing part (20) which is pivotable relative to the first, and also having an arrangement for pivotably connecting the first housing part (10) to the second housing part (20) according to one of claims 1 to 7.

9. Distribution cabinet according to claim 8, wherein the first hinge element (11) is supported in form-locked fashion by at least one part of the first housing part (10).

10. Distribution cabinet according to one of claims 8 or 9,
wherein the second hinge element (21) is supported in form-locked fashion by at least one part of the second housing part (20).

11. Distribution cabinet according to one of claims 8 to 10,
wherein the first housing part (10) is designed as a cabinet body and the second housing part (20) as a cabinet door.

12. Distribution cabinet according to one of claims 8 to 10,
wherein the first housing part (10) is designed as a cabinet door and the second housing part (20) as a cabinet body.

## Revendications

1. Agencement pour la liaison pivotante d'une première partie de boîtier (10) avec une deuxième partie de boîtier (20) d'une armoire de distribution, avec
- un premier élément à charnière (11), lequel peut être fixé au moyen d'une vis de positionnement (12) à une paroi latérale de la première partie de boîtier (10) et présente un organe à axe (14), lequel est prévu pour la réalisation d'un mouvement de rotation de la deuxième partie de boîtier (20) autour d'un axe de rotation (D),
- un deuxième élément à charnière (21), lequel peut être couplé de manière fixe à la deuxième partie de boîtier (20) et présente un logement (22) pour l'organe à axe (14), pour relier la première partie de boîtier (10) à la deuxième partie de boîtier (20) de manière pivotante,
dans lequel le premier élément à charnière (11) présente un boulon fileté (15), qui est vissé dans un alésage fileté (16) de l'élément à charnière (11), de sorte que la position de l'organe à axe (14) par rapport à la première partie de boîtier (10) est réglable dans une direction y, laquelle est orientée transversalement à l'axe de rotation et pour l'essentiel perpendiculairement à la paroi latérale de la première partie de boîtier (10),
- dans lequel le premier élément à charnière (11) présente une vis de contre-blocage (17), laquelle coopère avec le boulon fileté (15) de telle sorte que lors du serrage de la vis de contre-blocage (17) la position du premier élément à charnière (11) dans la direction y est fixée.

2. Agencement selon la revendication 1, dans lequel la vis de contre-blocage (17) est montée à rotation dans un alésage (19) du boulon fileté (15) et présente un filetage interne (18), au moyen duquel la vis de contre-blocage (17) peut être vissée contre la vis de positionnement (12), pour fixer le boulon fileté (15) dans la direction y.

3. Agencement selon l'une des revendications précédentes, les éléments séparés du premier élément à charnière (11) ainsi que du deuxième élément à charnière (21) présentant un matériau métallique, afin de permettre une mise à la terre entre la première partie de boîtier (10) et la deuxième partie de boîtier (20).

4. Agencement selon la revendication 3, dans lequel la première et la deuxième partie de boîtier (10, 20) présentent un matériau métallique et la mise à la terre est réalisable par le biais de saillies de grattage réalisées sur le deuxième élément à charnière (11, 21).

5. Agencement selon l'une des revendications précédentes, dans lequel la position de la deuxième partie de boîtier (20) par rapport à la première partie de boîtier (10) peut être modifiée dans une direction z, laquelle est orientée parallèlement à l'axe de rotation (D), à l'aide d'un moyen d'ajustement (23) réalisé sur le deuxième élément à charnière (21).

6. Agencement selon la revendication 5, dans lequel le moyen d'ajustement est réalisé en tant qu'excentrique (23), dont la première extrémité est montée à rotation dans le deuxième élément à charnière (21) autour d'un axe orienté transversalement à l'axe de rotation (D), et dont la deuxième extrémité s'appuie contre la deuxième partie de boîtier (20).

7. Agencement selon l'une des revendications précédentes, dans lequel le premier élément à charnière (11) et/ou le deuxième élément à charnière (21) sont maintenus par complémentarité de formes par le biais d'un élément de fermeture supplémentaire.

8. Armoire de distribution avec une première partie de boîtier (10) et une deuxième partie de boîtier (20) pivotant par rapport à celle-ci ainsi qu'avec un agencement pour la liaison pivotante de la première partie de boîtier (10) avec la deuxième partie de boîtier (20) selon l'une des revendications 1 à 7.

9. Armoire de distribution selon la revendication 8, dans laquelle le premier élément à charnière (11) est maintenu par complémentarité de formes au moins par le biais d'une partie de la première partie de boîtier (10).

10. Armoire de distribution selon l'une des revendications 8 ou 9, dans laquelle le deuxième élément à charnière (21) est maintenu par complémentarité de formes par le biais d'au moins une partie de la deuxième partie de boîtier (10).

11. Armoire de distribution selon l'une des revendications 8 à 10, dans laquelle la première partie de boîtier (10) est réalisée en tant que corps d'armoire et la deuxième partie de boîtier (20) en tant que portes d'armoire.

12. Armoire de distribution selon l'une des revendications 8 à 10, dans laquelle la première partie de boîtier (10) est réalisée en tant que portes d'armoire et la deuxième partie de boîtier (20) en tant que corps d'armoire.
